# EUROPÄISCHE PATENTSCHRIFT

(11) **EP 3 427 430 B1**
(45) Veröffentlichungstag und Bekanntmachung des Hinweises auf die Patenterteilung: **21.07.2021**
(21) Anmeldenummer: 17700506.3
(22) Anmeldetag: 11.01.2017
(51) Int. Cl.: H04L 1/18, H04L 1/00

(54) **VERFAHREN ZUR ÜBERTRAGUNG VON DATEN ÜBER EINEN GESTÖRTEN FUNKKANAL SOWIE EMPFANGSEINHEIT UND SENDEEINHEIT ZUR VERWENDUNG BEI DEM VERFAHREN**
METHOD FOR TRANSFERRING DATA VIA A DISRUPTED RADIO CHANNEL AND RECEIVING UNIT AND TRANSMITTING UNIT FOR USE IN THE METHOD
PROCÉDÉ DE TRANSMISSION DE DONNÉES PAR LE BIAIS D'UN CANAL RADIO PERTURBÉ AINSI QU'UNITÉ DE RÉCEPTION ET UNITÉ D'ÉMISSION DESTINÉES À ÊTRE UTILISÉES DANS LE PROCÉDÉ

(30) Priorität: 11.03.2016 DE 102016204039; 14.06.2016 DE 102016210492
(43) Veröffentlichungstag der Anmeldung: 16.01.2019
(73) Patentinhaber: VOLKSWAGEN AKTIENGESELLSCHAFT, 38440 Wolfsburg (DE)
(72) Erfinder: HEHN, Thorsten, 85055 Etting (DE)
(86) Internationale Anmeldenummer: PCT/EP2017/050468
(87) Internationale Veröffentlichungsnummer: WO 2017/153066

(56) Entgegenhaltungen:
- EP-A2- 1 168 703
- US-A1- 2005 149 841
- US-A1- 2013 223 485

## Beschreibung

Die Erfindung betrifft ein Verfahren zur Übertragung von Daten über einen gestörten Funkkanal, wobei die Daten mit Fehlerschutz übertragen werden in Form von Vorwärtsfehlerkorrekturdaten. Der Vorschlag betrifft weiterhin eine Sende- und eine Empfangseinheit zur Verwendung bei dem Verfahren.

### Hintergrund der Erfindung

Für das Szenario von mit Funkkommunikationsmodulen ausgestatteten Fahrzeugen, die im öffentlichen Straßenverkehr direkt miteinander kommunizieren, sei es für ein kooperatives oder autonomes Fahren, ist eine sehr hohe Verlässlichkeit für sicherheitskritische Anwendungen sehr wichtig. Techniken für die Fahrzeug-zu-Fahrzeug Direktkommunikation wurden bereits entwickelt und werden weiterentwickelt. Als Beispiel werden erwähnt die Fahrzeug-Direktkommunikation über WLAN, hier insbesondere die Variante nach dem WLAN Standard IEEE 802.11p. Bei dieser Technik werden zur Kommunikation zwischen den Fahrzeugen ad hoc WLAN Netze aufgebaut (Kommunikation im Bereich der "Ad Hoc Domain").

Fahrzeugkommunikation ist aber auch im Bereich der Mobilfunknetze möglich. Bei dieser Technik muss allerdings die Basisstation die Nachrichten von Fahrzeug zu Fahrzeug vermitteln. Das ist der Bereich, wo die Kommunikation in der sogenannten "Infrastructure Domain" stattfindet. Für die kommende Mobilfunkgeneration wird auch die Fahrzeugdirektkommunikation ermöglicht. Bei LTE heißt diese Variante LTE-V, bei der 5G Initiative heißt diese Variante D2D. Dies ist auch der Bereich der Fahrzeugkommunikation mit dem sich die vorliegende Erfindung beschäftigt.

Typische Kommunikations-Szenarien sind Sicherheitsszenarien, Verkehrseffizienzszenarien und Infotainment. Für den Bereich Sicherheit werden folgende Szenarien genannt: "Cooperative Forward Collision Warning", "Pre-Crash Sensing/Warning", "Hazardous Location Warning". In diesen Bereichen tauschen die Fahrzeuge untereinander Informationen wie Position, Richtung und Geschwindigkeit aus, auch Parameter wie Größe und Gewicht. Weitere Informationen die übertragen werden betreffen Absichtsinformationen, wie Fahrzeug beabsichtigt zu überholen, Fahrzeug biegt links/rechts ab, usw. die für das kooperative Fahren interessant sind. Dabei werden oft Sensordaten übermittelt. Falls eine Gefahrensituation vorliegt und der Fahrer nicht reagiert, könnte das Auto automatisch abbremsen, so dass ein Unfall verhindert wird oder zumindest die Folgen bei dem unvermeidlichen Unfall möglichst gering gehalten werden.

Im Bereich Verkehrseffizienz werden genannt: "Enhanced Route Guidance and Navigation", "Green-Light Optimal Speed Advisory" und "V2V Merging Assistance".

Im Bereich Infotainment steht der Internet-Zugang im Vordergrund.

Die Auflistung zeigt, dass insbesondere im Bereich Sicherheit zeitkritische Datenübertragungen stattfinden. Daher ist die Verlässlichkeit der Fahrzeug-zu-FahrzeugKommunikation von entscheidender Bedeutung.

Im Mobilfunk bedeutet Verlässlichkeit der Datenübertragung Vollständigkeit (alle gesendeten Nutzdaten kommen beim Empfänger an) und Korrektheit (die gesendeten Nutzdaten und die aus den empfangenen Daten zurückgewonnenen Nutzdaten stimmen überein). Dazu werden in den Mobilfunktechnologien verschiedene Methoden eingesetzt, z.B. Frequenzdiversität, räumliche Diversität, sinnvolle Wahl der Modulationsart und Modulationsparameter und des zu verwendenden Kanalcodes wie auch der Coderate, etc.!

Derzeit sind folgende Mobilfunktechnologien für die Fahrzeug zu Fahrzeugkommunikation anwendbar: 3GPP-basiertes UMTS, HSPA, LTE, und die kommenden 5G Standards. Für die Fahrzeugdirektkommunikation wird erwähnt LTE-V und 5G D2D. Bei all diesen Technologien werden Datensymbole mit Fehlerschutzdaten übertragen. Hier gilt es jedoch einen guten Kompromiss zu finden zwischen der Anzahl der Fehlerschutzdaten pro Symbol und dem gewünschten Datendurchsatz. Je mehr Fehlerschutzdaten hinzugefügt werden, umso geringer wird die Anzahl an Nutzdaten, die pro Zeiteinheit übertragen werden kann. Aus diesem Grund wird im Mobilfunk die Methode Hybrid-Automatic Repeat Request (HARQ) implementiert nach der Transportblöcke, die trotz des Fehlerschutzes nicht zurückgewonnen werden konnten, wiederholt bzw. ergänzt werden. Es wird jedenfalls entweder durch einfache Wiederholung des Blocks Redundanz nachgeliefert oder durch Nachlieferung von vorher ausgelassener Redundanz der Fehlerschutz sukzessive erhöht.

Dies bedeutet, dass ein Datenblock oder im Sprachgebrauch von Mobilfunkstandards ein Transportblock, in der Regel mit Vorwärtsfehlerkorrekturdaten FEC (Forward Error Correction) geschützt wird. Der Empfänger versucht, unter Verwendung der FEC-Daten den Transportblock zu dekodieren. Gelingt dies nicht, wird der Sender gebeten, zusätzliche Redundanz, d.h. mehr Fehlerschutzdaten zu senden. Mit den ursprünglich empfangenen Daten und der zusätzlichen Redundanz wird ein neuer Dekodierversuch gestartet.

Wie oben erwähnt, ist der HARQ-Prozess ein zentrales Element zum Sicherstellen der geforderten Verlässlichkeit bei der Datenübertragung. Dieser wird auf Senderseite installiert und sendet, basierend auf Antworten vom Empfänger, adaptiv zusätzliche Daten, die die Robustheit der Gesamtübertragung erhöhen. In der Praxis wird oft das Mobilfunknetz so eingestellt, dass jedes zehnte empfangene Transportblock, der ein FEC-Paket enthält fehlerhaft ist (Packetfehlerrate = 10%), bevor der HARQ-Prozess greift. Die Paketfehlerrate hinter dem HARQ-Prozess ist deutlich geringer, z.B. 10⁻⁵. Der HARQ-Prozess benötigt jedoch Zeit, daher erhöht er die Latenz der Datenübertragung.

Für LTE / 5G-basierte Direkt-Kommunikation zwischen Fahrzeugen, insbesondere für die Sicherheitsszenarien, ist eine sehr hohe Verlässlichkeit bei möglichst geringer Verzögerung (Latenz) nötig. Der in 3GPP verwendete HARQ-Prozess wurde bereits zu 3G-Zeiten standardisiert und ist seitdem nicht mehr grundlegend verändert worden.

Im Folgenden wird die Funktionsweise des in 3GPP spezifizierten HARQ-Prozesses kurz erläutert:
- Die Daten werden mit einem Turbocode der Coderate 1/3 codiert. Dieser Turbo-Coder erhält am Eingang einen Eingangs-Datenstrom und bildet drei Ausgangsdatenströme. Der erste besteht aus den Daten des Eingangsdatenstromes (Systematic Bits), die anderen beiden werden jeweils durch einen Faltungsencoder gebildet. Es entstehen so die Fehlerschutzdaten (zwei unterschiedliche Faltungscodes).
- Die drei Ströme werden punktiert und gemultiplext. Dies bedeutet, dass nur eine bestimmte Auswahl an Bits aus den drei Strömen übertragen wird und die drei Ströme zu einem Strom serialisiert werden.
- Das Resultat wird über die Luftschnittstelle an das User Equipment (UE) also die Empfangsstation versendet.
- Bestätigt das UE den erfolgreichen Empfang der Daten (ACK), werden keine weiteren Schritte eingeleitet.
- Kann das UE die Daten nicht erfolgreich dekodieren so signalisiert es dies auch (NACK), greifen verschiedene Mechanismen, um das UE weiter zu unterstützen, so dass eine erfolgreiche Decodierung ggf. doch noch ermöglicht wird.
   - Methode 1: "Incremental Redundancy": Dem UE wird mehr Information zur Dekodierung gesendet. Dies ist beispielsweise Information, die vorher beim Punktieren herausgenommen wurde, oder aber die Wiederholung von Systematic Bits. Das UE kombiniert die vorher und aktuell empfangene Information (z.B. durch "Soft Combining") und startet den Dekodierversuch erneut.
   - Methode 2: "Chase Combining": alle Daten werden wiederholt. Im Empfänger werden die beiden Sätze an Daten kombiniert und es wird ein erneuter Dekodierversuch mit dem kombinierten Ergebnis gestartet. Diese Methode ist weniger effizient und wird als letzte Instanz gewählt.

Eine Beschreibung des bestehenden HARQ-Prozesses im Mobilfunk findet sich in "Overview of ARQ and HARQ in Beyond 3G Systems" von Cipriano, Gagneur, Vivier und Sezginer in 2010 IEEE 21st International Symposium on Personal, Indoor and Mobile Radio Communications Workshops.

Aus der US 2013/223485 A1 ist ein HARQ Verfahren bekannt, bei dem ein Multi-Bit-Feedback vom Empfänger zum Sender zurück übertragen wird. Das Multi-Bit-Feedback Signal gibt an, welchen Grad der Konvergenz ein Decoder bei der Dekodierung der zuvor übertragenen Daten erlangt hat. Der Sender wird dabei so konfiguriert, dass er einen Satz codierter Datenbits für eine erneute Übertragung als Funktion des Multi-Bit-Feedback Signals auswählt. In einigen Ausführungsformen können verschiedene Redundanzversionen der codierten Daten als Funktion des Multi-Bit-Feedback Signal ausgewählt werden. In anderen Ausführungsformen kann ein Bitpunktierungs- oder Bitwiederholungsmuster als Funktion des Multi-Bit-Feedback Signal ausgewählt werden.

### Erfindung

Bestrebungen die bekannten Mobilfunksysteme für die Fahrzeugkommunikation einzusetzen führten zu der Beobachtung, dass diese hinsichtlich der geforderten Verlässlichkeit stärker herausgefordert sind. Insbesondere hinsichtlich der Latenz der Datenübertragungen besteht ein Problem. Mit der Erfindung wird der Ansatz verfolgt den bestehenden HARQ-Prozess zu verbessern im Hinblick auf die Verlässlichkeit der Datenübertragungen mit dem primären Fokus auf die Verbesserung der Latenz der Datenübertragung. Dies ist wichtig insbesondere für die Anpassung der zukünftigen 5G-Mobilfunksysteme für die Direktkommunikation zwischen Fahrzeugen.

Diese Aufgabe wird durch ein Verfahren zur Übertragung von Daten über einen gestörten Funkkanal gemäß Anspruch 1, eine Empfangseinheit gemäß Anspruch 7 und eine Sendeeinheit gemäß Anspruch 12 gelöst.

Die abhängigen Ansprüche beinhalten vorteilhafte Weiterbildungen und Verbesserungen der Erfindung entsprechend der nachfolgenden Beschreibung dieser Maßnahmen.

Im erweiterten HARQ-Prozess (nachfolgend HARQ+-Prozess genannt) sendet die Empfangsstation eine zusätzliche Feedbackinformation neben dem ACK/NACK Signal. Mit dieser Zusatzinformation, soll ausgedrückt werden, welcher der beiden Decoder, die kooperativ einen Fehlerschutzcode auswerten, beim Decoding Prozess stärker herausgefordert war. Dies hat den besonderen Vorteil, dass durch diese Zusatzinformation das Verfahren nach Methode 1 (Incremental Redundancy) besser auf den aktuellen Fall adaptiert und für das UE und den aktuellen Fall besser maßgeschneidert werden kann. Dadurch wird die Wahrscheinlichkeit zur erfolgreichen Dekodierung beim UE erhöht. Damit wird der HARQ-Prozess effizienter: er benötigt weniger Anläufe, um dem UE die Daten zur Verfügung zu stellen. Damit schont er den Kanal als Ressource und er verringert die Latenzzeit der Datenübertragung.

In der Feedback-Nachricht, also der HARQ+-Anforderungsnachricht wird deshalb ein zusätzliches Feld vorgesehen in das die Zusatzinformation eingetragen werden kann.

Wird ein heutiger Turbo-Code eingesetzt, bei dem zwei Decoder zusammenarbeiten um die Daten zurückzugewinnen, wird nur ein Feld mit 1 Bit Breite in der HARQ+-Anforderungsnachricht zusätzlich benötigt.

Um diese zusätzliche Feedbackinformation am Empfänger zu generieren müssen die beiden Decoder mitteilen können, wie schwierig die Dekodieraufgabe war. Diese Aufgabe wird in den meisten Decodern durch den sogenannten Viterbi-Algorithmus bewerkstelligt. Dieser sucht die wahrscheinlichste Bit-Sequenz und berechnet für diese Bit-Sequenz eine Pfad-Metrik, um diese Entscheidung zu treffen. Der Pfad mit der kleinsten akkumulierten Metrik = Pfadmetrik wird gewählt. Diese Pfad-Metriken können als Kriterium dafür dienen, wie stark der Decoder herausgefordert war. Durch einen Vergleich der Pfad-Metriken, die in den beiden Decodern berechnet wurden, wird es einfach möglich zu bestimmen, welcher der Decoder mehr Schwierigkeiten bei der Decodierung hatte. Es wird daher in diesem Ausführungsbeispiel davon ausgegangen, dass der Decoder, der die größere Pfad-Metrik berechnet hat die größeren Schwierigkeiten hatte.

Für eine Empfangseinheit gemäß der Erfindung ist es vorteilhaft, wenn sie neben der Decodereinheit mit einer Anzahl von Decodern einen Prozessor aufweist, und der Prozessor ermittelt, welcher Decoder die größten Schwierigkeiten hatte, das empfangene Datensymbol zu decodieren. Der Prozessor veranlasst dann die Absendung einer erweiterten HARQ-Anforderungsnachricht, nachfolgend HARQ+-Anforderungsnachricht genannt, mit der der Sendeseite mitgeteilt wird, welcher Decoder die größten Schwierigkeiten mit der Dekodierung des empfangenen Datensymbols hatte. Dazu weist die Empfangseinheit ein entsprechendes Kommunikations-Modul auf.

Für eine Sendeeinheit gemäß der Erfindung ist es vorteilhaft, wenn sie neben der Encodiereinheit einen Prozessor aufweist, der eine empfangene erweiterte HARQ-Anforderungsnachricht, auswertet mit der eine Empfangsstation noch weitere Redundanz für das Datensymbol anfordert. Der Prozessor veranlasst daraufhin die erneute Aussendung des Datensymbols, wobei bei der erneuten Aussendung gezielt mehr Fehlerschutzdaten wenigstens von demjenigen Encoder in dem Datensymbol vorgesehen werden, der in der HARQ+-Anforderungsnachricht als der Decoder mit den größten Decodierschwierigkeiten gekennzeichnet wurde. Dazu weist die Sendeeinheit ein entsprechendes Kommunikations-Modul auf. Dabei werden von der Sendeeinheit bei der erneuten Aussendung mehr Fehlerschutzdaten für den wenigstens einen betroffenen Decoder in das Datensymbol eingefügt, als nach dem üblichen HARQ-Prozess für diesen Schritt vorgesehen ist.

Eine vorteilhafte Ausgestaltung der Sendeeinheit besteht darin, das die Encodiereinheit schon zu Beginn der Übertragung eines Datensymbols mehrere Versionen des Datensymbols erstellt, die für den erweiterten HARQ-Prozess vorgehalten werden, wobei in den verschiedenen Versionen der Fehlerschutz pro Decoder sukzessive erhöht wird.

### Zeichnungen

Ein Ausführungsbeispiel der Erfindung ist in den Zeichnungen dargestellt und wird nachfolgend anhand der Figuren näher erläutert.

Es zeigen:
- Fig. 1: das Prinzip der Fahrzeugkommunikation über Mobilfunk;
- Fig. 2: ein Blockschaltbild eines Turbo Encoders;
- Fig. 3: ein Blockschaltbild eines entsprechenden Turbo Decoders, und dessen Funktionsweise während der Phase der Initialisierung;
- Fig. 4: ein Blockschaltbild eines Turbo Decoders, und dessen Funktionsweise während der Phase der Decodierung von empfangenen Daten;
- Fig. 5: das Format einer erweiterten HARQ-Anforderungsbotschaft gemäß einer Variante der Erfindung;
- Fig. 6: ein Blockschaltbild einer Empfangseinheit die für die Fahrzeugkommunikation gemäß der Erfindung ausgelegt ist;
- Fig. 7: ein Flussdiagramm für ein Programm dass von dem Prozessor in der Empfangseinheit gemäß der Erfindung abgearbeitet wird;
- Fig. 8: die Formate von verschiedenen Versionen eines mit Fehlerschutz versehenen codierten Datenblocks für den bestehenden HARQ-Prozess, wobei die Redundanz der Daten, d.h. der Fehlerschutz von oben nach unten zunimmt;
- Fig. 9: die Formate von weiteren Versionen eines mit Fehlerschutz versehenen codierten Datenblocks für den erweiterten HARQ-Prozess, wobei die Redundanz der Daten, d.h. der Fehlerschutz von oben nach unten zunimmt;
- Fig. 10: ein Blockschaltbild einer Sendeeinheit die für die Fahrzeugkommunikation gemäß der Erfindung ausgelegt ist;
- Fig. 11: ein Flussdiagramm für ein Programm dass von dem Prozessor in der Sendeeinheit gemäß der Erfindung abgearbeitet wird.

### Detaillierte Beschreibung der Ausführunasbeispiele der Erfindung

Die vorliegende Beschreibung veranschaulicht die Prinzipien der erfindungsgemäßen Offenbarung. Es versteht sich somit, dass Fachleute in der Lage sein werden, verschiedene Anordnungen zu konzipieren, die zwar hier nicht explizit beschrieben werden, die aber Prinzipien der erfindungsgemäßen Offenbarung verkörpern.

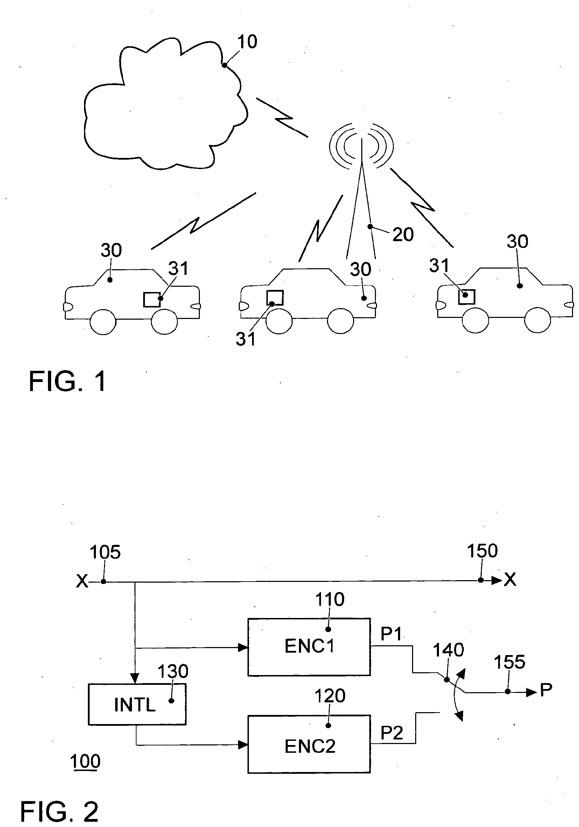

Fig. 1 zeigt das Prinzip der Fahrzeugkommunikation mittels Mobilfunk. Die Fahrzeuge sind mit Bezugszahl 30 versehen. Sie sind jeweils mit einer On-Board Unit 31 ausgestattet, die als Sende- und Empfangseinheit für die Mobilkommunikation dient. Alle Nachrichten von den Fahrzeugen (Uplink) und zu den Fahrzeugen (Downlink) werden entweder über eine Basisstation 20 geleitet, die eine Mobilfunkzelle bedient oder im Fall von Fahrzeugdirektkommunikation (Sidelink) unmittelbar zwischen den Fahrzeugen ausgetauscht. Befinden sich die Fahrzeuge innerhalb dieser Mobilfunkzelle, sind sie bei der Basisstation 20 angemeldet bzw. eingebucht. Verlassen sie die Mobilfunkzelle, werden sie an die benachbarte Zelle übergeben (Hand Over) und dementsprechend an der Basisstation 20 abgemeldet bzw. ausgebucht. Die Basisstation 20 stellt auch einen Zugang zum Internet zur Verfügung, so dass die Fahrzeuge 30 bzw. alle anderen Mobilfunk-Teilnehmer in der Mobilfunkzelle mit Internetdaten versorgt sind.

Diese Techniken sind standardisiert und es wird diesbezüglich auf die entsprechenden Spezifikationen von Mobilfunkstandards hingewiesen. Als ein modernes Beispiel eines Mobilfunkstandards wird auf die 3GPP Initiative und den LTE-Standard (Long Term Evolution) Bezug genommen. Viele der zugehörigen ETSI Spezifikationen liegen z.Z. in der Version 13 vor. Als Beispiel wird genannt: ETSI TS 136 213 V13.0.0 (2016-05);
Evolved Universal Terrestrial Radio Access (E-UTRA);
Physical layer procedures
(3GPP TS 36.213 version 13.0.0 Release 13).

In dem LTE-Standard sind mehrere Fehlerschutzmaßnahmen spezifiziert. Für die Kanalcodierung, so z.B. ein 24 Bit CRC Prüfcode für die Fehlererkennung in Transportblöcken, und die Verwendung von einem Vorwärtsfehlerkorrekturcode (FEC) basierend auf einem leistungsfähigen Turbo Code.

Ein Transportblock besteht aus den Nutzdaten, wobei nach Definition gemäß LTE-Standard eine maximale Anzahl von 6144 Bits an Nutzdaten im Transportblock untergebracht werden können, den Fehlerkorrekturdaten FEC und dem 24 Bit CRC-Prüfcode. Ein Transportblock ohne dem CRC-Prüfcode entspricht einem FEC-Block, enthält also einen Block von Nutzdaten, der mit Vorwärtsfehlerkorrekturdaten geschützt ist. Es wird diesbezüglich ausdrücklich auf den entsprechenden Teil des LTE-Standards Bezug genommen im Hinblick auf die Offenbarung der Erfindung. Dieser Teil lautet: ETSI TS 136 212 V13.1.0 (2016-04); LTE; Evolved Universal Terrestrial Radio Access (E-UTRA); Multiplexing and channel coding (3GPP TS 36.212 version 13.1.0 Release 13).

Im Encoder auf Senderseite werden Transportblöcke FEC-encodiert und im Decoder auf Empfängerseite werden die Transportblöcke FEC-decodiert. Die FEC-Encodierung von Transportblöcken geschieht laut LTE-Standard mit einem Turbo Code. Ein Turbo-Code nutzt Faltungscodes, und einen zwischengeschalteten Verwürfeler (Interleaver). Ein Turbo-Code erscheint er wie ein Block-Code, bei dem also die Nutzdaten getrennt von den Fehlerschutzdaten in einem Block versammelt sind.

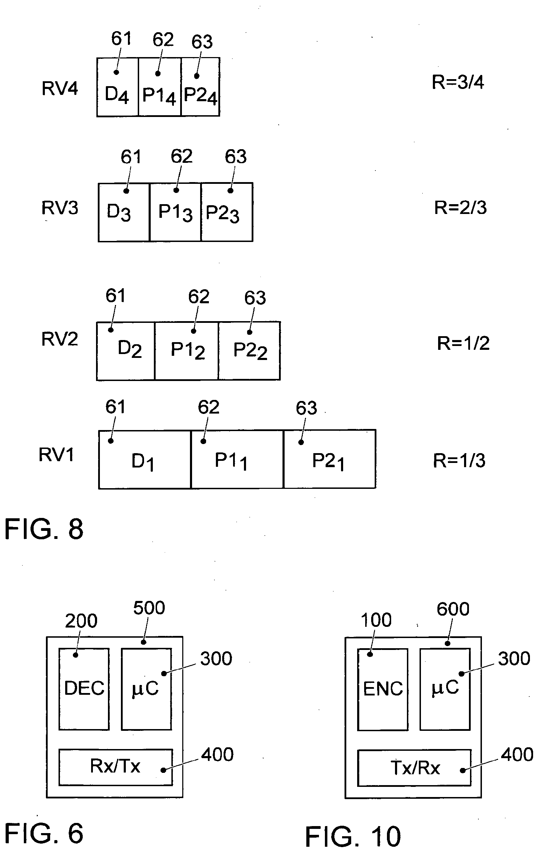

Fig. 2 zeigt die prinzipielle Struktur eines Turbo-Encoders 100. Die zu codierenden Nutzdaten X stehen am Eingang 105 an. Diese Nutzdaten X erscheinen, bei der sogenannten systematischen Encodierung, auch wieder am Ausgang 150 in unveränderter Form. Die Nutzdaten werden in einem ersten Faltungsencoder 110 encodiert. Die erzeugten Daten am Ausgang entsprechen Fehlerschutzdaten = Parity-Bits P1. Die Nutzdaten X werden auch einem Verwürfeler 130 = Interleaver zugeführt, der die Nutzdaten verwürfelt, also zusammengehörige Nutzdaten mit anderen Nutzdaten vermischt, um die Auswirkungen von Block-Fehlern zu verringern. Die vom Interleaver 130 ausgegebenen Daten werden einem zweiten Faltungsencoder 120 zugeführt, der parallel zu dem ersten Faltungsencoder 110 angeordnet ist. Dieser erzeugt einen zweiten Satz von Fehlerschutzdaten = Parity Bits P2. Beide Sätze an Fehlerschutzdaten werden über einen Schalter 140 abwechselnd zum zweiten Ausgang 155 geführt. Am Ausgang des Encoders 100 erscheinen also die Nutzdaten X, die ersten Fehlerschutzdaten P1 und die zweiten Fehlerschutzdaten P2 jeweils "En Block" in gemultiplexter Form. Im Vorgriff auf Fig. 8 wird an dieser Stelle schon erwähnt, dass die Fig. 8 verschiedene Varianten des Paket-Formats, zeigt wie die encodierten Daten allerdings nach Punktierung am Ausgang des Encoders 100 erscheinen.

Der große Vorteil der Turbo-Codes besteht darin, dass der der Decoder iterativ arbeitet und dadurch deutlich niedrigere Fehlerraten als herkömmliche Faltungscodes ermöglicht.

Für nähere Einzelheiten zu dem bei LTE verwendeten Turbo-Coder wird auf die bereits zitierte LTE Spezifikation ETSI TS 136 212 verwiesen.

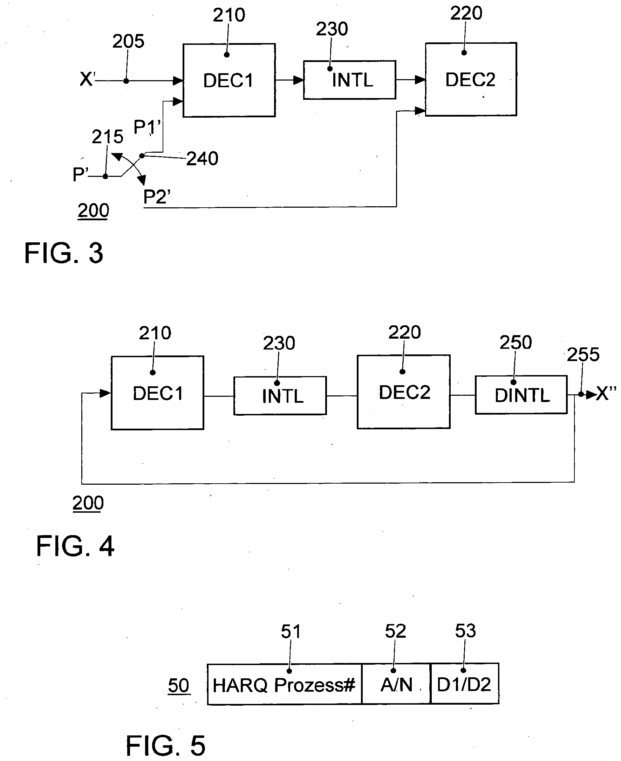

Fig. 3 zeigt ein Blockschaltbild für den Decoder 200 der empfangsseitig vorgesehen ist und den Turbo Code auswerten soll. Fig. 3 zeigt die Datenzuführung zu den beiden seriell verschalteten Faltungsdecodern 210 und 220. Der Faltungsdecoder 210 wertet den Faltungscode P1' aus und der Faltungsdecoder 220 den Faltungscode P2'. Die gestrichene Markierung von X, P1 und P2 deutet an, dass die entsprechenden Daten fehlerbehaftet sein können. Faltungsdecoder 210 bekommt die empfangenen Nutzdaten X' in der Reihenfolge ihres Eingangs während Faltungsdecoder 220 die von Decoder 210 decodierten Nutzdaten in verwürfelter Reihenfolge erhält. Dazu ist der Verwürfeler 230 zwischen Decoder 210 und 220 vorgesehen. Dadurch wird erreicht, dass das decodierte Datenbit von X' und P1' zum selben Zeitpunkt an Decoder 220 ansteht wie das zugehörige P2' Bit, dass über den Schalter 215 an den Eingang von Decoder 220 angelegt wird.

Fig. 4 zeigt noch die Arbeitsweise der Decodereinheit 200 nach Initialisierung. Die einzelnen Decoder 210 und 220 führen beispielsweise jeweils den Viterbi-Algorithmus durch. Sie ermitteln dabei die wahrscheinlichste Sequenz, die den empfangenen fehlerbehafteten Datenbits X', P1' und P2' am ehesten entspricht. Für alle punktierten Bits muss der jeweilige Decoder die Wahrscheinlichkeit von 50% ansetzen dafür, dass das Bit den Wert "1" aufweist und dafür, dass das Bit den Wert "0" aufweist. Diese Sequenz wird im Entwürfeler (Deinterleaver) 250 in die Ausgangsposition zurückgebracht und auf den Eingang zurückgeführt. So durchläuft die Sequenz den Decoder in einer Anzahl von Iterationen, wobei das Schätzergebnis immer genauer wird. Nach z.B. 10 Iterationen wird das Ergebnis am Ausgang 255 ausgegeben. Dieses Ergebnis entspricht den zurückgewonnenen Nutzdaten X". Sollte das Ergebnis doch nicht fehlerfrei sein, so wird das bei der nachfolgenden Prüfung des CRC Prüfcodes für den Transportblock festgestellt und es wird der HARQ-Prozess für diesen Transportblock angefordert.

Dazu wird von der Empfangseinheit, die den Decoder 200 enthält, eine HARQ-Anforderungsbotschaft zur Sendeeinheit zurückgesendet. Gemäß der Erfindung wird eine erweiterte HARQ-Anforderungsbotschaft gesendet, dessen Format in Fig. 5 gezeigt ist. Diese HARQ+-Anforderungsbotschaft enthält neben den üblichen Feldern 51 für die HARQ-Prozessnummer und 52 für das ACK/NACK-Bit ein Feld 53 für ein oder mehrere Bits, die angeben welcher Faltungsdecoder 210 oder 220 bei der Decodierung der Eingangsdaten die größeren Schwierigkeiten hatte. Der Decoder 200 muss also diese Information für eine Weile zur Verfügung stellen (abspeichern). Wenn der Decoder 200 nur zwei Faltungsdecoder 210, 220 beinhaltet, reicht es also aus, dass das Feld 53 in der HARQ+-Anforderungsbot-schaft nur eine Breite von einem Bit hat. Sollten mehr Faltungsdecoder in dem Decoder vorgesehen sein, sollten entsprechend mehr Bits in der HARQ+-Anforderungsbotschaft vorgesehen werden.

Für die Gewinnung der Information welcher Decoder die größeren Schwierigkeiten hatte, wird die Eigenart des Viterbi-Algorithmus ausgenutzt, dass durch diesen Algorithmus eine Pfadmetrik ausgerechnet wird für den bestimmten optimalen Viterbi-Pfad. Der Wert entspricht im einfachsten Fall der Hamming-Distanz zwischen dem empfangenen Datensymbol und dem decodierten Datensymbol. Je größer dieser Wert ist, umso fehlerbehafteter ist das empfangene Datensymbol und umso mehr Schwierigkeiten hatte der Faltungsdecoder die empfangenen Daten zu decodieren.

Fig. 6 zeigt ein einfaches Blockschaltbild einer Empfangseinheit 500. Diese besteht aus Decoder 200 Kommunikationsmodul 400 und Mikrocontroller 300. Der notwendige Speicher ist Decoder 200, Kommunikationsmodul 400 und Mikrocontroller 300 jeweils enthalten. Eine solche Empfangseinheit 500 kann zusammen mit einer entsprechenden Sendeeinheit als On-Board Unit 31 in den Fahrzeugen 30 eingesetzt werden. Die Sendeeinheit wird später bei der Beschreibung von Fig. 10 erläutert. Diese empfangen ja einerseits Daten von der Basisstation 20 (Downlink) und senden andererseits Daten zu der Basisstation (Uplink) oder empfangen und/oder senden Daten von/zu den anderen Fahrzeugen (Sidelink).

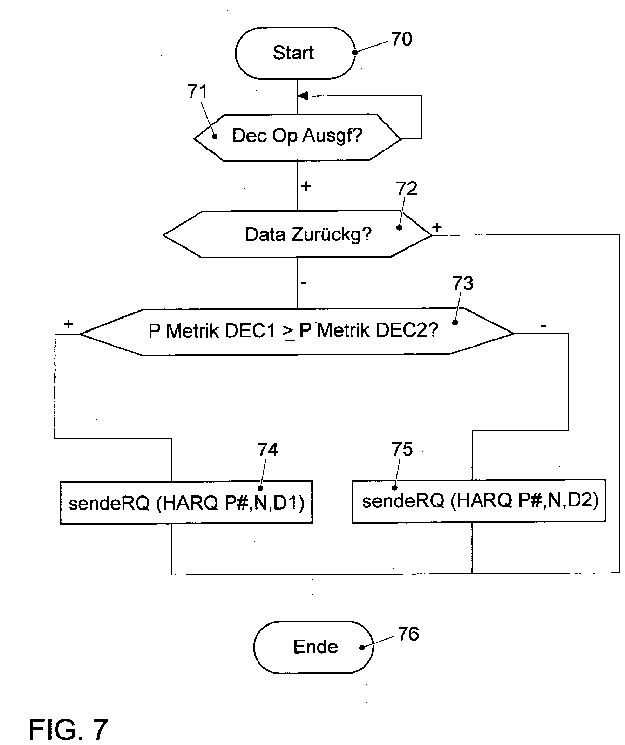

Die Empfangseinheit 500 bildet die HARQ+-Anforderungsbotschaft. Dies geschieht mit Hilfe des Mikrocontrollers 300. Dieser arbeitet nach einem Programm, dessen Flussdiagramm in Fig. 7 dargestellt ist. Das Programm beginnt in Programmschritt 70. In Schritt 71 wartet das Programm auf die fertige Decodierung der Eingangsdatenfolge des Decoders 200. Wenn das inklusive der Überprüfung des CRC-Prüfcodes der Fall ist, wird in Abfrage 72 geprüft ob die Daten fehlerfrei zurückgewonnen werden konnten. Wenn ja, endet das Programm in Schritt 76. Konnten die Daten nicht fehlerfrei zurückgewonnen werden, erfolgt in Abfrage 73 die Ermittlung welcher Faltungsdecoder 210, 220 die größeren Schwierigkeiten bei der Decodierung des Turbo Codes hatte. Dazu werden die in den Faltungsdecodern berechneten Pfadmetriken miteinander verglichen. Ist die von Faltungsdecoder 210 berechnete Pfadmetrik größer, so hatte dieser Decoder die größeren Decodierungsschwierigkeiten. In dem Fall bildet der Mikrocontroller 300 in Programmschritt 74 die HARQ+-Anforderungsbotschaft mit dem Eintrag, dass Decoder 210 in Bitfeld 53 angegeben wird. In Feld 52 ist in diesem Fall das Bit für die negative Bestätigung NACK gesetzt. Ebenfalls ist in Feld 51 die passende HARQ-Prozessnummer eingetragen. Ist die von Faltungsdecoder 220 berechnete Pfadmetrik größer, so hatte dieser Decoder die größeren Decodierungsschwierigkeiten. In dem Fall bildet der Mikrocontroller 300 in Programmschritt 75 die HARQ+-Anforderungsbotschaft mit dem Eintrag, dass Decoder 220 in Bitfeld 53 angegeben wird. Damit endet das Programm in Schritt 76. Alternativ können andere/erweiterte Methoden zur Ermittlung welcher Decoder die größeren Decodierungsschwierigkeiten hatte eingesetzt werden. Eine Methode wäre das Einbetten von Pilotsymbolen, deren Inhalt dem Empfänger bereits bekannt ist. Hier könnte der Empfänger beobachten, welcher Decoder über die Iterationen hinweg mehr Beitrag zum erfolgreichen Decodieren dieser Information beiträgt (Fortschrittsbeobachtung). Die Decoder mit kleinerem Beitrag sind stärker herausgefordert.

Fig. 8 zeigt wie der übliche HARQ-Prozess bei dem LTE Standard abläuft. Zunächst sendet die Sendestation einen Transportblock mit geringer Redundanz. Wie beschrieben wird ein Turbo Code eingesetzt für die FEC-Encodierung. Also besteht ein Transportblock aus einer Anzahl Nutzdaten D und den Fehlerschutzdaten P1 und P2. Zu Beginn berechnet der Encoder 100 den Code mit einer Coderate von R=1/3; also aus einem Nutzdatenbit erzeugt er drei Bits, nämlich das Nutzdatenbit und zwei Parity-Bits. Dies stellt gleichzeitig die Version RV1 mit der größten Redundanz dar. Der entsprechende FEC-Block ist in Fig. 8 unten gezeigt und enthält die Nutzdaten D₁ in Feld 61 und die zugehörigen Parity-Bits R1₁ und P2₁ in den Feldern 62 und 63.

Die Versionen mit niedrigerer Redundanz (Redundancy Version) RV2 bis RV4 werden durch Punktierung aus der Version RV1 erhalten. Punktierung ist ein Prozess in dem einzelne Bits aus den codierten Daten der Version RV1 weggelassen werden. Dies geschieht jeweils nach einem Punktierungsschema welches auch auf Empfängerseite bekannt sein muss. Dazu zählt der Mikrocontroller 300 auf Empfängerseite mit, welche Version an Redundanz gerade empfangen wurde. Die Version mit der geringsten Redundanz entspricht in Fig. 8 der Version RV4. Darin wird der Transportblock wie dargestellt mit Coderate R=¾ gesendet. Damit startet die Datenübertragung des Transportblocks in dem hier gewählten Ausführungsbeispiel. Wenn der Block nicht fehlerfrei decodiert werden konnte, wird nach dem bestehenden HARQ-Prozess als Nächstes der Block RV3 mit Coderate R=2/3 gesendet. Darin wird die Redundanz für beide Faltungsdecoder 210 und 220 gleichzeitig erhöht. Bei erneutem Scheitern des Decodiervorgangs, wird im nächsten Schritt die Version RV2 gesendet, in der der Transportblock mit Coderate R=½ gesendet wird. Scheitert der Decodiervorgang erneut, wird schlussendlich der Transportblock ohne Punktierung der Daten mit Coderate R=1/3 gesendet. Wie beschrieben, wird während des HARQ-Prozesses die Coderate sukzessive verringert. Dabei wird die Redundanz in jedem Schritt für jeden der beiden Faltungsdecoder gleichmäßig erhöht.

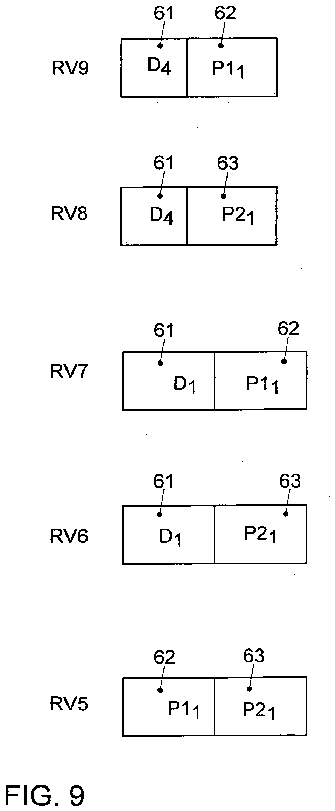

Nach dem erweiterten HARQ-Prozess wird die Redundanzerhöhung pro Schritt für denjenigen Faltungsdecoder 210, 220 maßgeschneidert, der im vorhergehenden Schritt die größten Decodierschwierigkeiten hatte. Dazu wird, nach der ersten Übertragung des FEC-Blockes in Version RV4 mit der Coderate R=¾ gemäß Fig. 9 die Version RV9 gesendet, wenn mitgeteilt wurde, dass der erste Faltungsencoder 210 das größere Problem hatte oder es wird die Version RV8 gesendet, wenn in der HARQ+-Anforderungsbotschaft 50 signalisiert wurde, dass der Faltungsdecoder 220 das größere Problem bei der Decodierung hatte. Wie gezeigt, wird eine beträchtliche Redundanzsteigerung für den betroffenen Decoder eingestellt während der andere Decoder keine Steigerung erfährt. Im gezeigten Fall von RV9 bekommt der erste Faltungsdecoder 210 die Daten ohne Punktierung übermittelt, also gleich mit der höchsten Redundanzstufe. Die Nutzdaten D4 werden wie zuvor mit gleicher Punktierung übermittelt. Der zweite Faltungsdecoder 220 muss dann wieder mit den bereits zuvor übermittelten Redundanzdaten P2₄ arbeiten. Im Fall von RV8 sind die Verhältnisse umgekehrt, wobei der zweite Decoder die vollen Redundanzdaten erhält und der erste Faltungsdecoder mit den vorher übermittelten Redundanzdaten P1₄ arbeiten muss. Der Vorteil besteht darin, dass der Decoder mit den größten Decodierschwierigkeiten die vollen Redundanzdaten erhält in einer wiederholten Ausstrahlung des Transportblocks wobei der Transportblock selbst nicht länger ist als der Transportblock der 1. Wiederholung (Retransmission) nach dem herkömmlichen HARQ-Prozess. Da beide Faltungsdecoder den Code kooperativ auswerten, wird auch das Ergebnis des zweiten Faltungsdecoders verbessert, wenn der erste Faltungsdecoder mit weniger Decodierschwierigkeiten zu kämpfen hat. Dadurch wird insgesamt die Latenzzeit der Datenübertragung verringert.

Konnte der Block nach der 2. Iteration noch nicht korrekt zurückgewonnen werden, und hat nun Faltungsdecoder 220 das größere Problem mit der Decodierung der Daten, so wird bei der 3. Übertragung des Transport-Blockes die Version RV8 gesendet, womit der Faltungsdecoder 220 die vollen Parity Daten P2₁ erhält (ohne Punktierung).

Konnte der Block dann noch immer nicht fehlerfrei zurückgewonnen werden, wird je nach dem welcher Decoder die größeren Schwierigkeiten hatte die Version RV7 oder RV6 übermittelt. Darin finden sich neben den vollen Redundanzdaten P1₁ oder P2₁ auch die systematischen Nutzdatenbits D₁ ohne Punktierung also ebenfalls vollständig.

Als Alternative steht noch die Version RV5 zur Verfügung. Darin befinden sich die Faltungscodes P1 und P2 der beiden Faltungsdecoder 210 und 220 vollständig ohne Punktierung. Allerdings werden keine Nutzdatenbits in dieser Variante übertragen. Diese Variante kann im HARQ+-Prozess übertragen werden, wenn nach der ersten Übertragung festgestellt wird, dass beide Faltungsdecoder 210, 220 die gleichen Schwierigkeiten mit der Decodierung des FEC-Blockes haben.

Es sind auch weitere Varianten denkbar, die statt oder zusätzlich zu den beschriebenen Varianten in dem HARQ+-Prozess eingesetzt werden können. Jede Variante, in der in dem jeweiligen Schritt für einen Faltungsdecoder mehr Redundanzdaten übermittelt werden als in den Versionen RV3 und RV2 vorzugsweise bei gleicher Länge des Blockes sollte ebenfalls einsetzbar sein.

Fig. 10 zeigt ein einfaches Blockschaltbild einer Sendeeinheit 500. Diese besteht aus Encoder 100 Kommunikationsmodul 400 und Mikrocontroller 300. Der notwendige Speicher ist in Encoder 100, Kommunikationsmodul 400 und Mikrocontroller 300 jeweils enthalten.

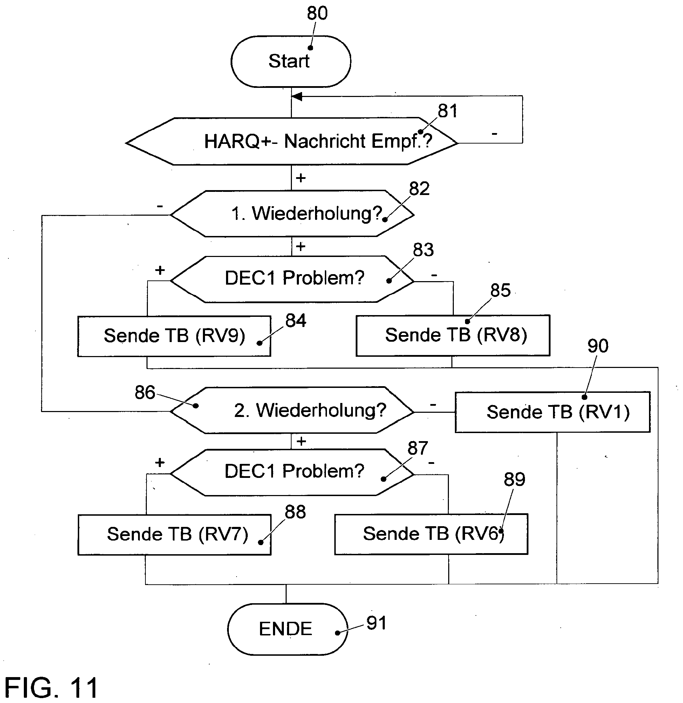

Die Arbeitsweise des Mikrocontrollers 300 in der Sendeeinheit 600 wird noch anhand von Fig. 11 erläutert. Dieses Programm wird für die Realisierung des HARQ+-Prozesses abgearbeitet. Das Programm startet in Programmschritt 80. In Abfrage 81 wird auf den Eingang einer HARQ+-Anforderungsnachricht gewartet. Wenn eine HARQ+-Anforderungsnachricht eingegangen ist, wird in Abfrage 82 geprüft ob es sich um die 1. Anforderung im HARQ+-Prozess handelt. Dazu muss im Mikrocontroller ein Zähler bei jedem Eintreffen einer HARQ+-Anforderungsbotschaft gesetzt werden, der bei Beendigung wieder gelöscht wird. Wenn ja, wird mit Abfrage 83 überprüft ob Faltungsdecoder 210 in der Anforderungsnachricht als problematisch signalisiert wurde. Ist es der Fall, wird im HARQ+-Prozess im Programmschritt 84 der Transportblock erneut gesendet mit dem FEC-Block in der Variante RV9. Anderenfalls wird in Schritt 85 ein Transportblock mit dem FEC-Block in der Variante RV8 gesendet um den Faltungsdecoder 220 zu unterstützen. Handelt es sich nicht um die 1. Anforderung im HARQ+-Prozess wird in Schritt 86 geprüft, ob es sich um die 2. Anforderung im HARQ+-Prozess handelt. Wenn ja, wird in Schritt 87 geprüft ob der Faltungsdecoder 210 in der Anforderungsnachricht als problematisch signalisiert wurde. Ist es der Fall, wird im HARQ+-Prozess im Programmschritt 88 der Transportblock erneut gesendet mit dem FEC-Block in der Variante RV7. Anderenfalls wird in Schritt 89 ein Transportblock mit dem FEC-Block in der Variante RV6 gesendet um den Faltungsdecoder 220 zu unterstützen. Handelt es sich nicht um die 2. Anforderungsnachricht im HARQ+-Prozess, so wird nach Abfrage 86 direkt der Transportblock mit dem FEC-Block gemäß der Variante RV1 gesendet. Dies entspricht dem Programmschritt 90. Das Programm endet dann im Schritt 91.

Es sollte verstanden werden, dass das vorgeschlagene Verfahren und die zugehörigen Vorrichtungen in verschiedenen Formen von Hardware, Software, Firmware, Spezialprozessoren oder einer Kombination davon implementiert werden können. Spezialprozessoren können anwendungsspezifische integrierte Schaltungen (ASICs), Reduced Instruction Set Computer (RISC) und / oder Field Programmable Gate Arrays (FPGAs) umfassen. Vorzugsweise wird das vorgeschlagene Verfahren und die Vorrichtung als eine Kombination von Hardware und Software implementiert. Die Software wird vorzugsweise als ein Anwendungsprogramm auf einer Programmspeichervorrichtung installiert. Typischerweise handelt es sich um eine Maschine auf Basis einer Computerplattform die Hardware aufweist, wie beispielsweise eine oder mehrere Zentraleinheiten (CPU), einen Direktzugriffsspeicher (RAM) und eine oder mehrere Eingabe/Ausgabe (I/O) Schnittstelle(n). Auf der Computerplattform wird typischerweise außerdem ein Betriebssystem installiert. Die verschiedenen Prozesse und Funktionen, die hier beschrieben wurden, können Teil des Anwendungsprogramms sein, oder ein Teil der über das Betriebssystem ausgeführt wird.

Die Offenbarung ist nicht auf die hier beschriebenen Ausführungsbeispiele beschränkt. Es gibt Raum für verschiedene Anpassungen und Modifikationen, die der Fachmann aufgrund seines Fachwissens als auch zu der Offenbarung zugehörend in Betracht ziehen würde.

## Patentansprüche

1. Verfahren zur Übertragung von Daten über einen gestörten Funkkanal, wobei die Daten mit Fehlerschutz übertragen werden in Form von Vorwärtsfehlerkorrekturdaten, wobei bei der Anwendung der Fehlerschutzdaten (62, 63) auf Empfängerseite eine Anzahl Decoder (210, 220) die Nutzdaten (61) kooperativ zurückgewinnen indem sie die jeweils ihnen zugeordneten Fehlerschutzdaten (62, 63) auswerten, wobei die Anzahl der Fehlerschutzdaten nach einem bestehenden HARQ-Prozess sukzessive erhöht wird, wenn der Funkkanal so gestört ist, dass die übertragenen Daten trotz des Fehlerschutzes nicht zurückgewonnen werden konnten, **dadurch gekennzeichnet, dass** in einem erweiterten HARQ-Prozess die Empfängerseite der Senderseite in einer erweiterten HARQ-Anforderungsnachricht (50), nachfolgend HARQ+-Anforderungsnachricht genannt, mitteilt, welcher der Decoder (210, 220) die größten Schwierigkeiten bei der Zurückgewinnung der Nutzdaten (61) hatte, woraufhin die Senderseite wenigstens diesem Decoder (210, 220) gezielt mehr Fehlerschutzdaten (62, 63) sendet als nach dem bestehenden HARQ-Prozess für diesen Schritt vorgesehen ist.

2. Verfahren nach Anspruch 1, wobei für die Mitteilung welcher der Decoder (210, 220) die größten Schwierigkeiten bei der Zurückgewinnung der Nutzdaten (61) hatte, ein zusätzliches Feld (53) für eine Anzahl von Bits in der HARQ+-Anforderungsnachricht (50) vorgesehen wird.

3. Verfahren nach Anspruch 1 oder 2, wobei zur Kanalcodierung der Nutzdaten (61) ein Turbo-Code verwendet wird, der auf Senderseite in einer Encodereinheit (100) mit mindestens zwei parallel arbeitenden Faltungsencodern (110, 120) erzeugt wird, wobei zur Übertragung der Daten ein Datenpaket (RV1 bis RV4) zusammengestellt wird in dem Nutzdaten (61), Fehlerschutzdaten (62) des ersten Faltungsencoders (110) und Fehlerschutzdaten (63) des mindestens einen zweiten Faltungsencoders (120) gemultiplext aufeinanderfolgen.

4. Verfahren nach Anspruch 3, wobei zur Decodierung der Nutzdaten (61) auf Empfängerseite eine Decodereinheit (200) vorgesehen ist, die mit mindestens zwei seriell arbeitenden Faltungsdecodern (210, 220) ausgestattet ist, denen jeweils die Nutzdaten (61) und die ihnen zugehörigen Fehlerschutzdaten (62, 63) zugeführt werden.

5. Verfahren nach Anspruch 3 oder 4, wobei, nur ein Feld (53) mit 1 Bit Breite in der HARQ+-Anforderungsnachricht zusätzlich vorgesehen wird für den Fall, dass ein Turbo-Code zum Einsatz kommt, der mit zwei Faltungsencodern (110, 120) erzeugt wird.

6. Verfahren nach einem der Ansprüche 3 bis 5, wobei auf Empfängerseite Pfadmetriken in den Faltungsdecodern (210, 220) berechnet werden, die angeben, welches Codewort am wahrscheinlichsten durch die empfangenen Daten repräsentiert wird, und wobei die Entscheidung welcher der Faltungsdecoder (210, 220) die größten Schwierigkeiten bei der Zurückgewinnung der Nutzdaten (61) hatte wenigstens darauf basiert, welcher der Faltungsdecoder (210, 220) die größte Pfadmetrik berechnet hat.

7. Empfangseinheit zur Verwendung bei dem Verfahren nach einem der vorhergehenden Ansprüche, aufweisend eine Decodiereinheit (200) mit einer Anzahl von Decodern (210, 220), die kooperativ ein empfangenes Datensymbol dekodieren, einem Kommunikations-Modul (400) und weiter aufweisend einen Prozessor (300), **dadurch gekennzeichnet, dass** der Prozessor (300) ermittelt, welcher Decoder (210, 220) die größten Schwierigkeiten hatte, das empfangene Datensymbol zu decodieren und dass der Prozessor (300) in einem erweiterten HARQ-Prozess die Absendung einer erweiterten HARQ-Anforderungsnachricht (50), nachfolgend HARQ+-Anforderungsnachricht genannt, veranlasst, mit der der Sendeseite mitgeteilt wird, welcher Decoder (210, 220) die größten Schwierigkeiten mit der Dekodierung des empfangenen Datensymbols hatte.

8. Empfangseinheit nach Anspruch 7, wobei die Decodiereinheit (200) mindestens zwei Faltungsdekoder (210, 220) aufweist, und die mindestens zwei Faltungsdekoder (210, 220) jeweils eine Pfadmetrik berechnen, die angibt, welches Codewort am wahrscheinlichsten durch das empfangene Datensymbol repräsentiert wird.

9. Empfangseinheit nach Anspruch 8, **dadurch gekennzeichnet, dass** der Prozessor (300) zur Ermittlung welcher Faltungsdecoder (210, 220) die größten Schwierigkeiten hatte, das empfangene Datensymbol zu decodieren einen Vergleich der berechneten Pfadmetriken vornimmt und denjenigen Faltungsdecoder (210, 220) als den mit den größten Schwierigkeiten bestimmt, dessen berechnete Pfadmetrik den größeren Wert aufweist.

10. Empfangseinheit nach einem der Ansprüche 7 bis 9, **dadurch gekennzeichnet, dass** der Prozessor (300) die Information über den Faltungsdecoder (210, 220) mit den größten Decodierschwierigkeiten in einem zusätzlichen Feld (53) mit einer Anzahl von Bits in die HARQ+-Anforderungsnachricht (50) einträgt.

11. Empfangseinheit nach Anspruch 10, wobei der Prozessor (300) für den Fall, dass die Decodiereinheit (200) mit nur zwei Faltungsdekodern (210, 220) ausgestattet ist, als zusätzliches Feld (53) in der HARQ+-Anforderungsnachricht (50) ein 1-Bit Feld einfügt.

12. Sendeeinheit zur Verwendung bei dem Verfahren nach einem der vorhergehenden Ansprüche 1 bis 6, aufweisend eine Encodiereinheit (100) mit einer Anzahl von Encodern (110, 120), die ein zu sendendes Datensymbol enkodieren in dem sie jeweils eigene Fehlerschutzdaten generieren, ein Kommunikationsmodul (400) und weiter aufweisend einen Prozessor (300), der so arbeitet, dass die Anzahl der Fehlerschutzdaten in einem Datensymbol nach einem bestehenden HARQ-Prozess sukzessive erhöht wird, wenn der Funkkanal so gestört ist, dass die übertragenen Daten trotz des Fehlerschutzes nicht zurückgewonnen werden konnten, **dadurch gekennzeichnet, dass** der Prozessor (300) weiterhin so arbeitet, dass er eine empfangene erweiterte HARQ-Anforderungsnachricht, nachfolgend HARQ+-Anforderungsnachricht (50) genannt, auswertet mit der eine Empfangsstation die nochmalige Aussendung des Datensymbols nach einem erweiterten HARQ-Prozess anfordert, und dass der Prozessor (300) die erneute Aussendung des Datensymbols veranlasst, wobei bei der erneuten Aussendung gezielt mehr Fehlerschutzdaten (62, 63) wenigstens von demjenigen Encoder (110, 120) in dem Datensymbol vorgesehen werden, dessen zugeordneter Decoder (210, 220) in der HARQ+-Anforderungsnachricht als der Decoder mit den größten Decodierschwierigkeiten gekennzeichnet wurde, wobei die Sendeeinheit bei der erneuten Aussendung gezielt mehr Fehlerschutzdaten für den wenigstens einen betroffenen Decoder in das Datensymbol einfügt, als nach dem bestehenden HARQ-Prozess für diesen Schritt vorgesehen ist.

13. Sendeeinheit nach Anspruch 12, wobei die Encodiereinheit (100) schon zu Beginn der Übertragung eines Datensymbols mehrere Versionen des Datensymbols erstellt, die für den erweiterten HARQ-Prozess vorgehalten werden, wobei in den verschiedenen Versionen der Fehlerschutz sukzessive erhöht wird.

## Claims

1. Method for transmitting data via a disrupted radio channel, wherein the data are transmitted with error protection in the form of forward error correction data, wherein, in the use of the error protection data (62, 63), a number of decoders (210, 220) cooperatively recover the useful data (61) on the receiver side by evaluating the error protection data (62, 63) in each case allocated to them, wherein the number of error protection data items is successively increased according to an existing HARQ process if the radio channel is so disrupted that the transmitted data could not be recovered despite the error protection, **characterized in that**, in an extended HARQ process, the receiver side notifies the transmitter side in an extended HARQ request message (50), referred to below as an HARQ+ request message, of which of the decoders (210, 220) had the greatest difficulties in recovering the useful data (61), whereupon the transmitter side transmits more error protection data (62, 63) in a targeted manner at least to this decoder (210, 220) than is provided according to the existing HARQ process for this step.

2. Method according to Claim 1, wherein, for the notification of which of the decoders (210, 220) had the greatest difficulties in recovering the useful data (61), an additional field (53) is provided for a number of bits in the HARQ+ request message (50).

3. Method according to Claim 1 or 2, wherein, for the channel coding of the useful data (61), a turbo code is used which is generated on the transmitter side in an encoder unit (100) with at least two parallel operating convolutional encoders (110, 120), wherein, for the transmission of the data, a data packet (RV1 to RV4) is assembled in which useful data (61), error protection data (62) of the first convolutional encoder (110) and error protection data (63) of the at least one second convolutional encoder (120) follow one another in multiplexed form.

4. Method according to Claim 3, wherein a decoder unit (200) is provided on the receiver side to decode the useful data (61), said decoder unit being equipped with at least two serially operating convolutional decoders (210, 220), to which the useful data (61) and the error protection data (62, 63) associated with them are fed in each case.

5. Method according to Claim 3 or 4, wherein only one field (53) having a 1-bit width is additionally provided in the HARQ+ request message in the case where a turbo code is used which is generated with two convolutional encoders (110, 120).

6. Method according to one of Claims 3 to 5, wherein path metrics which indicate which code word is most likely to be represented by the received data are calculated in the convolutional decoders (210, 220) on the receiver side, and wherein the decision as to which of the convolutional decoders (210, 220) had the greatest difficulties in recovering the useful data (61) is based at least on which of the convolutional decoders (210, 220) has calculated the greatest path metric.

7. Receiving unit for use in the method according to one of the preceding claims, having a decoding unit (200) with a number of decoders (210, 220) which cooperatively decode a received data symbol, a communication module (400) and further having a processor (300), **characterized in that** the processor (300) determines which decoder (210, 220) had the greatest difficulties in decoding the received data symbol, and **in that** the processor (300) in an extended HARQ process initiates the transmission of an extended HARQ request message (50), referred to below as an HARQ+ request message, with which the transmitting side is notified of which decoder (210, 220) had the greatest difficulties with the decoding of the received data symbol.

8. Receiving unit according to Claim 7, wherein the decoding unit (200) has at least two convolutional decoders (210, 220) and the at least two convolutional decoders (210, 220) in each case calculate a path metric which indicates which code word is most likely to be represented by the received data symbol.

9. Receiving unit according to Claim 8, **characterized in that**, in order to determine which convolutional decoder (210, 220) had the greatest difficulties in decoding the received data symbol, the processor (300) carries out a comparison of the calculated path metrics and identifies the convolutional decoder (210, 220) whose calculated path metric has the greater value as the one with the greatest difficulties.

10. Receiving unit according to one of Claims 7 to 9, **characterized in that** the processor (300) records the information relating to the convolutional decoder (210, 220) with the greatest decoding difficulties in an additional field (53) with a number of bits in the HARQ+ request message (50).

11. Receiving unit according to Claim 10, wherein the processor (300) inserts a 1-bit field as an additional field (53) into the HARQ+ request message (50) in the case where the decoding unit (200) is equipped with only two convolutional decoders (210, 220) .

12. Transmitting unit for use in the method according to one of the preceding Claims 1 to 6, having an encoding unit (100) with a number of encoders (110, 120) which encode a data symbol to be transmitted by generating in each case dedicated error protection data, a communication module (400) and further having a processor (300) which operates in such a way that the number of error protection data items in a data symbol according to an existing HARQ process is successively increased if the radio channel is so disrupted that the transmitted data could not be recovered despite the error protection, **characterized in that** the processor (300) furthermore operates in such a way that it evaluates a received extended HARQ request message, referred to below as an HARQ+ request message (50), with which a receiving station requests the retransmission of the data symbol according to an extended HARQ process, and **in that** the processor (300) initiates the retransmission of the data symbol, wherein more error protection data (62, 63) are provided in a targeted manner in the data symbol in the retransmission at least by the encoder (110, 120) whose associated decoder (210, 220) was **characterized in** the HARQ+ request message as the decoder with the greatest decoding difficulties, wherein, in the retransmission, the transmitting unit inserts more error protection data in a targeted manner into the data symbol for the at least one affected decoder than is provided according to the existing HARQ process for this step.

13. Transmitting unit according to Claim 12, wherein the encoding unit (100) creates a plurality of versions of the data symbol already at the beginning of the transmission of a data symbol, said versions being retained for the extended HARQ process, wherein the error protection is successively increased in the different versions.

## Revendications

1. Procédé de transmission de données par le biais d'un canal radio perturbé, dans lequel les données sont transmises avec une protection contre les erreurs sous la forme de données de correction d'erreurs sans voie de retour,
dans lequel, lorsque les données de protection contre les erreurs (62, 63) sont appliquées côté récepteur, un certain nombre de décodeurs (210, 220) récupèrent en coopération les données utiles (61) en évaluant les données de protection contre les erreurs (62, 63) qui leur sont respectivement associées, dans lequel le nombre des données de protection contre les erreurs est augmenté successivement selon un processus HARQ existant lorsque le canal radio est perturbé de telle manière que les données transmises n'ont pas pu être récupérées malgré la protection contre les erreurs,
**caractérisé en ce que**, dans un processus HARQ étendu, le côté récepteur signale au côté émetteur dans un message de demande HARQ étendu (50), appelé ci-après message de demande HARQ+, lequel des décodeurs (210, 220) a eu les plus grandes difficultés à récupérer les données utiles (61), puis le côté émetteur transmet sélectivement à au moins ce décodeur (210, 220) davantage de données de protection contre les erreurs (62, 63) que ce qui est prévu pour cette étape selon le processus HARQ existant.

2. Procédé selon la revendication 1, dans lequel il est prévu un champ supplémentaire (53) pour un nombre de bits dans le message de demande HARQ+ (50) pour signaler celui des décodeurs (210, 220) qui a eu les plus grandes difficultés à récupérer les données utiles (61).

3. Procédé selon la revendication 1 ou 2, dans lequel on utilise pour le codage de canal des données utiles (61) un turbo-code qui est généré côté émetteur dans une unité de codage (100) comprenant au moins deux codeurs convolutifs (110, 120) fonctionnant en parallèle, dans lequel, pour la transmission des données, on compile un paquet de données (RV1 à RV4) dans lequel des données utiles (61), des données de protection contre les erreurs (62) du premier codeur convolutif (110) et des données de protection contre les erreurs (63) dudit au moins un second codeur convolutif (120) se suivent de manière multiplexée.

4. Procédé selon la revendication 3, dans lequel, pour le décodage des données utiles (61) côté récepteur, il est prévu une unité de décodage (200) qui est équipée d'au moins deux décodeurs convolutifs (210, 220) fonctionnant en série, à chacun desquels sont envoyées les données utiles (61) et les données de protection contre les erreurs (62, 63) qui leur sont associées.

5. Procédé selon la revendication 3 ou 4, dans lequel il est en outre prévu un seul champ (53) d'une largeur de 1 bit dans le message de demande HARQ+ en cas d'utilisation d'un Turbo-Code, lequel est généré au moyen de deux décodeurs convolutifs (110, 120).

6. Procédé selon l'une quelconque des revendications 3 à 5, dans lequel on calcule dans les décodeurs convolutifs (210, 220) côté récepteur des métriques de trajet qui indiquent quel mot de code a la probabilité la plus élevée d'être représenté par les données reçues, et dans lequel la décision de savoir lequel des décodeurs convolutifs (210, 220) a eu les plus grandes difficultés à récupérer les données utiles (61) est basée au moins sur celui des décodeurs convolutifs (210, 220) qui a calculé la plus grande métrique de trajet.

7. Unité de réception destinée à être utilisée dans le procédé selon l'une quelconque des revendications précédentes, comprenant une unité de décodage (200) comportant une pluralité de décodeurs (210, 220) décodant en coopération un symbole de données reçu, un module de communication (400) et comprenant en outre un processeur (300), **caractérisé en ce que** le processeur (300) détermine quel décodeur (210, 220) a eu les plus grandes difficultés à décoder le symbole de données reçu, et **en ce que** le processeur (300), dans un processus HARQ étendu, provoque la transmission d'un message de demande HARQ étendu (50), appelé ci-après message de demande HARQ+, au moyen duquel le côté émission est informé du décodeur (210, 220) qui a eu les plus grandes difficultés à décoder le symbole de données reçu.

8. Unité de réception selon la revendication 7, dans laquelle l'unité de décodage (200) comprend au moins deux décodeurs convolutifs (210, 220), et lesdits au moins deux décodeurs convolutifs (210, 220) calculent respectivement une métrique de trajet qui indique quel mot de code a la probabilité la plus élevée d'être représenté par le symbole de données reçu.

9. Unité de réception selon la revendication 8, **caractérisée en ce que**, pour déterminer quel décodeur convolutif (210, 220) a eu les plus grandes difficultés à décoder le symbole de données reçu, le processeur (300) effectue une comparaison des métriques de trajet calculées et détermine le décodeur convolutif (210, 220) dont la métrique de trajet calculée a la valeur la plus élevée comme étant celui présentant les plus grandes difficultés.

10. Unité de réception selon l'une quelconque des revendications 7 à 9, **caractérisée en ce que** le processeur (300) introduit dans le message de demande HARQ+ (50) l'information concernant le décodeur convolutif (210, 220) ayant les plus grandes difficultés de décodage dans un champ supplémentaire (53) présentant un certain nombre de bits.

11. Unité de réception selon la revendication 10, dans laquelle, dans le cas où l'unité de décodage (200) est équipée de seulement deux décodeurs convolutifs (210, 220), le processeur (300) introduit dans le message de demande HARQ+ (50) un champ de 1 bit en tant que champ supplémentaire (53).

12. Unité d'émission destinée à être utilisée dans le procédé selon l'une quelconque des revendications précédentes 1 à 6, comprenant une unité de codage (100) comportant une pluralité de codeurs (110, 120) qui codent un symbole de données à émettre en générant des données de protection contre les erreurs respectives, un module de communication (400), et comprenant en outre un processeur (300) ayant pour fonction d'augmenter successivement le nombre de données de protection contre les erreurs dans un symbole de données selon un processus HARQ existant, lorsque le canal radio est perturbé de telle manière que les données transmises ne peuvent pas être récupérées malgré la protection contre les erreurs, **caractérisé en ce que** le processeur (300) a en outre pour fonction d'évaluer un message de demande HARQ étendu reçu, appelé ci-après message de demande HARQ+ (50), au moyen duquel une station de réception demande la réémission du symbole de données après un processus HARQ étendu, et **en ce que** le processeur (300) déclenche la réémission du symbole de données, dans lequel la réémission prévoit sélectivement plus de données de protection contre les erreurs (62, 63) dans le symbole de données au moins à partir du codeur (110, 120) dont le décodeur associé (210, 220) a été identifié dans le message de demande HARQ+ comme ayant les plus grandes difficultés de décodage, dans lequel l'unité d'émission introduit sélectivement dans le symbole de données davantage de données de protection contre les erreurs pour ledit au moins un décodeur affecté pendant la réémission que ce qui est prévu pour cette étape selon le processus HARQ existant.

13. Unité d'émission selon la revendication 12, dans laquelle l'unité de codage (100) crée dès le début de la transmission d'un symbole de données plusieurs versions du symbole de données, qui sont conservées pour le processus HARQ étendu, dans lequel la protection contre les erreurs est successivement renforcée dans les différentes versions.
